# FASCICULE DE BREVET EUROPEEN

(11) **EP 0 721 218 B1**
(45) Date de publication et mention de la délivrance du brevet: **26.09.2001**
(21) Numéro de dépôt: 95410150.7
(22) Date de dépôt: 27.12.1995
(51) Int. Cl.: H01L 27/08

(54) **Circuit intégré de puissance**
Integrierte Leistungsschaltung
Power integrated circuit

(30) Priorité: 30.12.1994 FR 9416011
(43) Date de publication de la demande: 10.07.1996
(73) Titulaire: STMicroelectronics S.A., 94250 Gentilly (FR)
(72) Inventeur: Pezzani, Robert, F-37210 Vouvray (FR)
(74) Mandataire: de Beaumont, Michel

(56) Documents cités:
- DE-A- 3 421 185
- FR-A- 2 335 957
- US-A- 4 278 985

## Description

La présente invention concerne le domaine des composants pouvant supporter des tensions élevées et/ou transmettre de fortes puissances qui seront appelés ici composants de puissance. Ces composants sont réalisés de façon verticale sur toute l'épaisseur d'une tranche semiconductrice à partir d'un substrat à faible niveau de dopage pour permettre des tenues en tension élevées.

De façon classique, de tels composants de puissance sont des thyristors, des triacs, des transistors bipolaires, des transistors MOS de puissance, des transistors bipolaires à grille isolée (IGBT), etc.

Les composants destinés à gérer une puissance électrique importante sont nécessairement amenés à dissiper une certaine puissance thermique. Ainsi, leur face arrière est métallisée et montée sur un dissipateur thermique. Il en résulte que, si l'on veut réaliser plusieurs composants de puissance sur une même puce, ce n'est possible que dans le cas où ces divers composants ont une borne commune. Un autre composant est décrit dans DE-A-3 421 185.

La présente invention a pour objet de réaliser des circuits intégrés de puissance, c'est-à-dire de permettre de rassembler sur un même substrat des composants verticaux dont au moins une des couches est constituée par une partie faiblement dopée de ce substrat, la face arrière du substrat étant métallisée pour pouvoir être brasée ou assemblée d'une autre manière sur un dissipateur thermique.

Pour atteindre cet objet, la présente invention prévoit un assemblage monolithique de composants semiconducteurs de puissance verticaux formés sur toute l'épaisseur d'une plaquette semiconductrice d'un premier type de conductivité faiblement dopée dont la face arrière est uniformément revêtue d'une métallisation dans lequel certains au moins de ces composants, dits composants autonomes, sont formés dans des sections isolées du substrat. Ces "sections isolées" sont isolées latéralement par un mur diffusé du deuxième type de conductivité et leur fond est isolé par une couche diélectrique interposée entre la face arrière du substrat et la métallisation de face arrière.

Quand la région semiconductrice de face arrière d'un composant autonome est du premier type de conductivité, il est prévu du côté de la face arrière une région surdopée du premier type de conductivité et, du côté de la face avant, en regard d'une portion au moins de cette région surdopée de face arrière, une région surdopée du premier type de conductivité sur laquelle est pris un contact.

Quand la région semiconductrice de face arrière d'un composant autonome est du deuxième type de conductivité, cette région est prolongée latéralement jusqu'à un mur d'isolement, un contact étant repris sur la face supérieure du mur d'isolement, ladite couche diélectrique s'étendant sous les fondations inférieures du mur d'isolement.

Dans au moins une section isolée, peuvent être formés des composants logiques.

La présente invention s'applique à la réalisation d'un pont de diodes monolithique comprenant, dans un substrat d'un premier type de conductivité, deux premières diodes verticales dont la cathode commune correspond à une métallisation de face arrière et, dans une section isolée du substrat, séparée du reste du substrat par un mur d'isolement du deuxième type de conductivité, deux deuxièmes diodes verticales dont l'anode commune correspond à une couche du deuxième type de conductivité formée du côté de la face arrière dont le contact est repris du côté de la face supérieure par l'intermédiaire du mur d'isolement, la partie de surface inférieure de ces deux diodes étant revêtue d'une couche isolante interposée entre la tranche semiconductrice et la métallisation de face arrière.

L'invention s'applique aussi à la réalisation d'un composant comprenant un pont redresseur monophasé comprenant des première et deuxième paires de diodes tête-bêche entre des bornes d'alimentation alternative, les points de connexion des diodes de chaque paire de diodes constituant une borne d'alimentation continue, et deux diodes de Shockley en anti-parallèle sur les diodes d'une paire de diodes. Les diodes de Shockley et la première paire de diodes sont réalisées verticalement dans le substrat dont la face supérieure comprend deux premières métallisations d'alimentation alternative et dont la face inférieure comporte une troisième métallisation d'alimentation continue correspondant au raccordement des deux premières diodes, et la deuxième paire de diodes est réalisée dans une section isolée entre une quatrième métallisation d'alimentation continue et chacune des métallisations d'alimentation alternative.

Selon un avantage de la présente invention, on peut réaliser sur un même substrat semiconducteur des composants verticaux dont certains ont une électrode commune constituée de la métallisation de face arrière et dont d'autres sont autonomes, c'est-à-dire que leurs électrodes peuvent être connectées indépendamment à diverses bornes d'autres composants ou à des bornes extérieures, aucune de ces électrodes n'étant constituée de la métallisation de face arrière.

En outre, du fait que les composants autonomes sont protégés sur leur face arrière par une couche isolante mince telle qu'une couche d'oxyde de silicium, elle-même revêtue de la métallisation de face arrière, on conserve une bonne dissipation thermique même pour les composants dont la face arrière comprend cette couche mince qui est isolante électriquement mais reste conductrice thermiquement.

Bien que l'on décrive ci-après seulement certains composants particuliers assemblables pour former un circuit intégré de puissance ainsi qu'éventuellement des circuits logiques associés et certaines applications de ces circuits, l'invention n'est pas limitée à ces cas particuliers. L'homme de l'art pourra relever une analogie entre les composants autonomes selon la présente invention et les réalisations effectuées dans le domaine des circuits intégrés bipolaires. En effet, dans le domaine des circuits intégrés bipolaires, l'essentiel des composants d'un circuit intégré est formé dans une couche épitaxiée, les divers composants étant isolés entre eux par des diffusions profondes traversant la couche épitaxiée et leur fond étant isolé par des couches enterrées de l'un ou l'autre type de conductivité. Selon l'invention, c'est toute l'épaisseur du substrat qui correspond à la couche épitaxiée et l'isolement par jonction (couche enterrée) de fond est remplacé par la couche isolante interposée entre la face arrière du substrat et la métallisation de face arrière.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :
les figures 1A et 1B représentent une vue en coupe et une vue schématique de divers types de diodes assemblables selon la présente invention ;
les figures 2A et 2B représentent une vue en coupe et une vue schématique de divers types de thyristors assemblables selon la présente invention ;
la figure 3A et 3B représentent une vue en coupe et une vue schématique de divers types de transistors NPN assemblables selon la présente invention ;
les figures 4A à 4B représentent une vue en coupe et une vue schématique de divers types de transistors PNP assemblables selon la présente invention ;
la figure 5 représente à titre d'exemple une vue en coupe d'un transistor de type IGBT "autonome" intégrable de façon monolithique selon la présente invention ;
les figures 6, 7, 8 et 9 représentent de façon conceptuelle les divers types de composants assemblables de façon monolithique selon la présente invention ;
la figure 10A représente un pont de diodes et les figures 10B et 10C une vue en coupe et une vue de dessus schématique d'un mode de réalisation selon la présente invention d'un tel pont de diodes ; et
les figures 11A, 11B, 11C, 12A, 12B, 13A, 13B, 14A, 14B, 14C illustrent une application de la présente invention à un pont redresseur protégé contre des surtensions et des surintensités.

Les diverses figures ne sont pas représentées à l'échelle, tant en ce qui concerne les vues en coupe que les vues de dessus. Au contraire les diverses dimensions ont été arbitrairement dilatées ou contractées pour faciliter la lecture des figures. Les régions diffusées ont été fortement symbolisées ; tantôt, elles ont été représentées de façon quelque peu réaliste avec des coins arrondis, tantôt, elles ont été représentées tout à fait symboliquement avec des coins carrés. De plus, dans chaque cas, l'homme de l'art saura adapter les surfaces relatives des diverses régions pour satisfaire aux caractéristiques de puissance exigées du composant.

Il sera clair pour l'homme de l'art que la présente invention ne présente que des structures de base de composants et que dans la pratique chacun de ces composants subira diverses améliorations et modifications en vue de mieux satisfaire au but requis. Par exemple, on n'a pas représenté de triacs mais seulement des thyristors et les courts-circuits d'anode ou de cathode de ces thyristors n'ont jamais été représentés.

### EXEMPLE DE COMPOSANTS ASSEMBLABLES SELON L'INVENTION

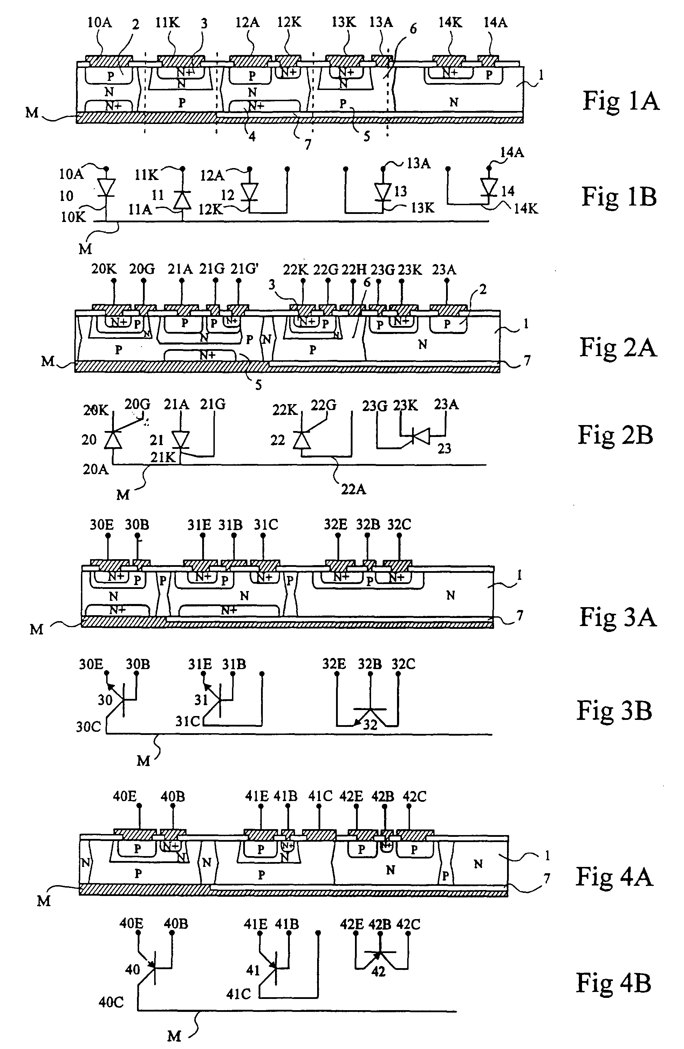

La figure 1A représente divers types de diodes 10 à 14 assemblables sur une même tranche semiconductrice de type N. La figure 1B représente sous forme symbolique chacune des diodes de la figure 1A. La structure est formée à partir d'un substrat 1 de type N faiblement dopé. Des diffusions 2 de type P peuvent être formées à partir de la surface supérieure de même que des diffusions 3 de type N fortement dopées. A partir de la face inférieure, on prévoit de former des diffusions de type N fortement dopées 4 et des diffusions de type P fortement dopées 5. En outre, on prévoit de former des murs d'isolement 6 de type P, à partir d'une diffusion de face supérieure et d'une diffusion en vis à vis de face inférieure. L'ensemble de la face arrière est revêtu d'une métallisation M. A certains emplacements, une couche isolante 7 est interposée entre la face arrière du composant et la métallisation M. La couche isolante 7 et la métallisation M peuvent être réalisées en tout matériau ou ensemble de matériaux usuels dans le domaine de la fabrication des composants semiconducteurs.

Dans ce qui suit, on appellera "section isolée" une portion de la tranche de silicium isolée latéralement par un mur du deuxième type de conductivité et dans son fond par une portion de couche isolante 7.

Les diodes 10 et 11 sont des diodes qui existent classiquement dans un composant de puissance. La diode 10 comprend verticalement, du haut vers le bas, une région de type P, une portion du substrat et une région de type N ; la métallisation de face supérieure correspond à sa métallisation d'anode 10A et la métallisation M de face arrière correspond à sa métallisation de cathode 10K. La diode 11 comprend verticalement, du haut vers le bas, une région de type N fortement dopée, une portion du substrat et une région de type P fortement dopée ; sa cathode 11K correspond à une métallisation de face supérieure et son anode à la métallisation M.

Cette réalisation classique des diodes 10 et 11 entraîne qu'elles ont nécessairement une borne commune et que, par exemple, il n'est pas possible de réaliser en assemblant de tels composants un pont de diodes dans lequel les diodes diagonalement opposées n'ont pas de bornes communes.

Les diodes 12 et 13 sont des diodes "autonomes" formées dans des sections isolées selon la présente invention qui présentent l'avantage d'avoir un fonctionnement vertical et de disposer d'électrodes d'anode et de cathode qui ne sont pas nécessairement communes avec celles d'un autre composant du circuit.

La diode 12 comprend verticalement, du haut vers le bas, une région de type P qui correspond à son anode, une portion du substrat et une région de type N fortement dopée qui correspond à sa cathode. Ainsi, la diode 12 est bien une diode verticale. En outre une région N est formée du côté de la face supérieure, en contact avec une métallisation 12K de reprise de contact de cathode.

La diode 13 comprend verticalement, du haut vers le bas, une région de type N correspondant à sa cathode 13K, une portion du substrat et une région de type P diffusée à partir de sa face arrière. Une métallisation d'anode 13A est formée sur la face supérieure du mur d'isolement délimitant la section isolée dans laquelle est formée cette diode 13.

On a en outre représenté à la droite de la figure 1A une diode latérale 14 également formée dans une section isolée. La diode 14 comprend une région de type N dont est solidaire une métallisation de cathode 14K, formée dans un caisson de type P diffusé dans le substrat 1 et solidaire d'une métallisation d'anode 14A. La diode 14 n'est pas un composant de puissance en raison de son fonctionnement latéral et pourrait constituer un élément d'un circuit logique associé sur une même puce à un ou plusieurs composants de puissance. Placer des circuits logiques dans des sections isolées constitue aussi un aspect de la présente invention car, en pratique, il était très difficile sinon impossible de réaliser de tels éléments logiques intégrés à des structures de puissance quand les structures de puissance comprenaient des composants quatre couches en raison de l'apparition inévitable de thyristors verticaux parasites.

Il faut noter que l'intégration de composants quatre couches (type thyristor) pose presque toujours des problèmes fonctionnels pour les composants intégrés dans la même puce. En effet, par couplage latéral, une diode ou un thyristor intégré va générer avec d'autres couches de la structure un thyristor parasite entraînant que la structure peut se mettre en court-circuit par amorçage de ce thyristor parasite et ne remplira donc pas la fonction escomptée. Dans le cas présent, les isolements latéral/arrière font que ces thyristors parasites disparaissent et ceci permet d'intégrer sans risque des composants ayant une fonction de thyristor avec d'autres composants logiques ou de puissance.

Les figures 2A et 2B illustrent diverses structures de thyristors réalisables selon la présente invention.

La partie gauche de la figure 2A illustre des thyristors classiques 20 et 21 dont, respectivement, l'anode et la cathode sont connectées à une métallisation de face arrière.

Le thyristor 20 comprend verticalement une région de type N correspondant à sa cathode 20K, une région de type P sur laquelle est prise le contact de gâchette 20G, une portion du substrat 1 et une région d'anode de type P qui est en contact avec la métallisation M qui correspond à l'anode 20A du thyristor. En outre, on a représenté un mur d'isolement latéral de ce thyristor mais ce mur d'isolement n'a pas dans ce cas particulier un rôle d'isolement mais, de façon classique, est utilisé pour former un thyristor à caisson susceptible de supporter des tensions élevées.

Le thyristor 21 est un composant complexe tel que décrit dans le brevet américain de la demanderesse N° 5365086 et a été représenté pour bien montrer que la présente invention permet d'assembler dans un même circuit intégré de puissance pratiquement tout composant élémentaire connu.

Dans la partie droite de la figure 2A, on a représenté des thyristors "autonomes" 22 et 23 formés dans des sections isolées.

Le thyristor 22 est un thyristor de puissance vertical qui comprend du haut vers le bas, une région de type N sur laquelle est prise la métallisation de cathode 22K, une région de type P, une portion du substrat de type N⁻ et une région de type P formée à partir de la face inférieure et solidaire d'un mur d'isolement 6 sur la face supérieure duquel est prise la métallisation d'anode 22A.

Le thyristor 23 est un thyristor latéral pouvant faire partie d'un circuit logique. Il comprend une région de cathode de type N solidaire d'une métallisation 23K formée dans une région de type P sur laquelle est prise le contact de gâchette 23G, cette région de type P étant formée dans le substrat. Dans ce même substrat est formée une région de type P dont est solidaire la métallisation d'anode 23A. Comme on l'a indiqué précédemment, l'avantage de disposer un tel thyristor latéral dans une section isolée de la tranche est que les couches constitutives de ce thyristor ne constitueront alors pas des éléments parasites avec d'autres éléments de la structure.

La figure 3A représente trois exemples de transistors NPN 30, 31, 32 réalisés selon la présente invention.

Le transistor 30 est un transistor vertical classique comprenant une région de type N dont est solidaire la métallisation d'émetteur 30E, une région de type P dont est solidaire la métallisation de base 30B, cette région de type P étant formée dans une portion du substrat et une région de type N fortement dopée étant formée dans la face arrière et étant solidaire de la métallisation de face arrière M qui correspond au collecteur.

Les transistors 31 et 32 sont formés dans des sections isolées du substrat.

Le transistor 31 est similaire au transistor 30 mais il comprend du côté de sa face supérieure une région de type N supplémentaire fortement dopée en regard d'une portion de la région de type N de face inférieure et cette région de type N supplémentaire est reliée à une métallisation de collecteur 31C.

Le transistor 32 est un transistor latéral et comprend, dans un caisson P, des régions de type N respectivement solidaires de métallisations d'émetteur 32E et de collecteur 32C, la région P étant solidaire d'une métallisation de base 32B. Ce transistor 32 pourra constituer un élément d'un circuit logique associé à un ou plusieurs composants de puissance.

De façon similaire, la figure 4A représente trois types de transistors PNP 40, 41, 42 réalisables selon la présente invention.

Le transistor PNP 40 est un transistor de puissance classique dont la face arrière correspond à la métallisation M et qui comprend, du côté de la face supérieure du substrat, une région de type P solidaire d'une métallisation 40E et une région de type N solidaire d'une métallisation de base 40B. Du côté de la face arrière, est formée une région P solidaire du substrat. De préférence, cette région P est solidaire de murs d'isolement.

Le transistor 41 est formé dans une section isolée. Il a la même structure que le transistor 40 mais le contact de collecteur 41C est repris sur la face supérieure du mur d'isolement latéral.

Le transistor 42, également formé dans une section isolée, est un transistor latéral PNP complémentaire du thyristor latéral NPN 32 décrit précédemment.

Ainsi, les composants illustrés en figures 1 à 4 représentent des éléments d'une bibliothèque de cellules de composants de puissance ou logiques qui peuvent être assemblés sur une même tranche selon une configuration souhaitée.

Selon les buts visés, on réalisera des composants de puissance à électrode commune ou des composants de puissance "autonomes" formés dans une ou plusieurs sections isolées dont les électrodes sont distinctes de celles des autres composants de la même puce.

Bien entendu, les composants des figures 1 à 4 ne représentent que des exemples de composants élémentaires qui peuvent être réalisés. Tous les composants de puissance connus se prêtent en fait à être utilisés dans des structures de puissance intégrées monolithiques selon l'invention. Par exemple, l'homme de métier pourra facilement passer des structures de thyristors illustrés en figures 2 à des structures de triacs. D'autre part, il pourra également prévoir des thyristors à gâchette d'anode autant qu'à gâchette de cathode.

Pour des raisons de clarté, toutes les alternatives n'ont pas été représentées et décrites. En particulier, en se référant à la figure 2A, on peut noter que la couche N centrale, peu dopée, n'a pas été totalement exploitée : on peut en effet y relier une électrode supplémentaire appelée "gâchette d'anode". Le procédé de réalisation n'en est pas compliqué puisque cette couche émerge dans tous les cas sur la face supérieure. On peut alors commander chacun des thyristors par sa gâchette de cathode (non représentée) ou cette gâchette d'anode (non représentée).

La description ci-dessus est volontairement simplifiée. Dans certains cas, il est possible et souhaitable d'enfermer dans le même caisson (avec ou sans isolement de face arrière) différents composants. A titre d'exemple, la diode 11 peut être réalisée dans le même caisson que le thyristor 21.

En respectant les règles précédentes, on peut aussi rajouter à un circuit intégré selon l'invention des éléments passifs tels que des résistances et capacités.

De plus la métallisation de face arrière du composant, essentiellement destinée à assurer une bonne liaison thermique avec un dissipateur thermique, n'est pas nécessairement reliée à une borne extérieure et peut seulement constituer un point de connexion interne de composants élémentaires du circuit intégré de puissance. Elle peut alors être isolée électriquement d'une structure de radiateur.

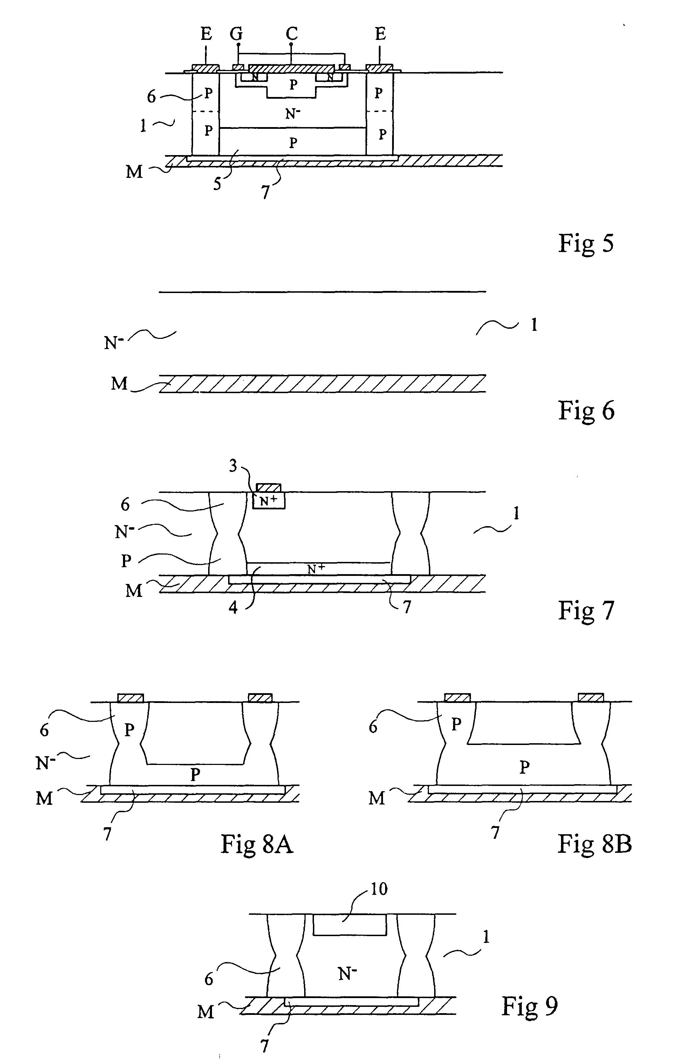

Uniquement à titre d'exemple, pour bien montrer la grande variété d'applications à laquelle se prête l'invention, la figure 5 représente un transistor IGBT (transistor bipolaire à grille isolée) réalisé selon la présente invention sous forme de composant autonome dans une section isolée d'une tranche semiconductrice.

On retrouve la structure classique d'un transistor IGBT comprenant, du côté de la face supérieure d'un substrat 1, une région de type P dans laquelle sont formées des régions de type N s'étendant près de la périphérie de la région de type P de façon à définir des zones où est susceptible de se former un canal surmontées d'une métallisation de grille G. Une métallisation de collecteur C est solidaire des régions de type N et d'une partie centrale surdopée de la région de type P. A partir de la face inférieure du substrat est également formée une région 5 de type P. Dans une structure classique, cette région de type P est solidaire de la métallisation de face arrière M du substrat qui constitue son émetteur. Ici, pour rendre le composant autonome, une couche d'isolement 7 est formée entre la région de type P et la métallisation M et le composant est entouré d'un mur d'isolement 6 de type P. Des contacts d'émetteur E sont repris sur la face supérieure de ce mur.

On notera donc que la présente invention permet d'associer dans un même cicuit intégré de puissance des composants de type MOS et de type bipolaire.

### EXPOSÉ GÉNÉRALISÉ DE L'INVENTION

Les figures 6 à 9 illustrent plus conceptuellement les divers types de composants pouvant être réalisés et assemblés de façon monolithique grâce à la présente invention.

Comme le représente la figure 6, des composants verticaux classiques peuvent être directement formés dans un substrat 1 de type N⁻ dont la face arrière est revêtue d'une métallisation qui correspond à une électrode commune de ces divers composants verticaux.

Comme le représente la figure 7, une première catégorie de composants autonomes peut être formée dans une section isolée du substrat, ces composants ayant en face arrière une couche active 4 du même type de conductivité que le substrat mais fortement dopée. Cette couche est séparée de la métallisation M de face arrière par une couche isolante 7 et le contact avec cette couche est établi par une région supplémentaire 3 du type de conductivité du substrat formée sur la face avant du substrat en regard d'une partie au moins de la couche 4. Bien entendu, dans ce cas, il existera une certaine résistance due à l'épaisseur du substrat entre les régions 3 et 4 et ce type de structure ne pourra être adopté que pour des composants susceptibles de supporter une haute tension mais non destinés à supporter des densités de courant élevées.

Comme le représente la figure 8A, une deuxième catégorie de composants autonomes peut être formée dans une section isolée du substrat, ces composants ayant en face arrière une couche active du type de conductivité opposé à celui du substrat. En ce cas, le contact est repris par les murs d'isolement 6. Ces murs d'isolement pouvant être constitués de zones relativement fortement dopées, on pourra utiliser de tels composants comme composants de forte puissance. Dans ce cas, la couche isolante 7 doit nécessairement s'étendre sous la région de face inférieure du composant et jusqu'aux limites externes des murs d'isolement.

Dans la variante de la figure 8B, on a représenté le cas où la région P de face inférieure est une région relativement épaisse occupant sensiblement la moitié de l'épaisseur du substrat et venant rejoindre une portion de mur d'isolement 6 formé à partir de la face supérieure.

Comme le représente la figure 9, une troisième catégorie de composants autonomes peut être formée dans une section isolée du substrat, ces composants étant destinés à constituer des éléments de circuits logiques formés dans un caisson 10 du type de conductivité opposé à celui du substrat.

### PONT DE DIODES

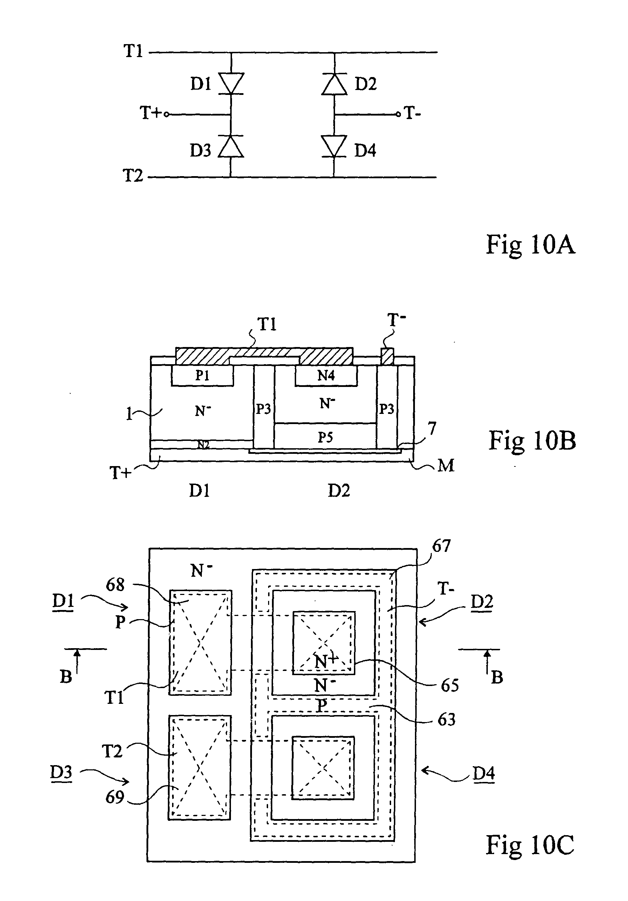

Un exemple d'application du mode d'assemblage monolithique de composants de puissance selon la présente invention va être décrit ci-après en relation avec un pont de diodes. Un pont de diodes, représenté en figure 10A comprend quatre diodes D1 à D4. L'anode commune des diodes D2 et D4 constitue la borne négative T⁻ du pont, la cathode commune des diodes D1 et D3 constitue la borne positive T⁺ du pont, les points d'interconnexion des diodes D1-D2 et D3-D4 constituent respectivement les bornes d'alimentation alternative T1 et T2 du pont.

La figure 10B représente une vue en coupe d'une réalisation selon la présente invention du pont de diodes de la figure 10A et la figure 10C en représente une vue de dessus, la figure 10B étant une vue en coupe prise selon les lignes B-B de la figure 10C.

Comme le représentent les figures 10B et 10C, les diodes D1 et D3 connectées par leur cathode sont réalisées sous forme de diodes verticales classiques et comprennent du côté supérieur d'un substrat 1 de type N faiblement dopé une région P1 de type P et du côté inférieur une région N2 de type N⁺ en contact avec une métallisation inférieure M qui correspond à la métallisation T⁺ de la figure 10A. Les diodes D2 et D4 sont formées dans des sections isolées du substrat séparées du reste du substrat par un mur P3 de type P classiquement obtenu à partir de diffusions profondes réalisées à partir des faces supérieure et inférieure. La face inférieure de ces sections isolées ainsi que la surface inférieure du mur P3 sont protégées par une couche d'un matériau diélectrique 7 tel que de l'oxyde de silicium. Chacune des diodes D2 et D4 comprend du côté de sa face supérieure une région de cathode N4 de type N⁺ formée dans le substrat N, ces régions N4 sont distinctes pour chacune des diodes D2 et D4. Du côté de la face inférieure, une région P5 de type P constitue l'anode commune des diodes D2 et D4. Le contact d'anode est repris par une métallisation T⁻. Une métallisation T1 relie la région P1 à la région N4 tandis qu'une métallisation T2 (voir figure 10C) relie la région correspondante de la diode D3 à la région correspondante de la diode D4.

Dans la vue de dessus, on a représenté par des croix les zones où les métallisations T1 et T2 sont en contact avec des zones semiconductrices sous-jacentes, les portions restantes de ces métallisations étant formées sur une couche d'oxyde.

### PONT REDRESSEUR PROTÉGÉ

La figure 11A représente un pont redresseur comprenant quatre diodes D1 à D4 connectées comme en figure 10A.

Pour protéger les diodes du pont et surtout les composants susceptibles d'être connectés aux bornes T⁺ et T⁻, on utilise généralement un composant de protection bidirectionnel S, tel qu'une double diode de Shockley disposée entre les bornes T1 et T2. Ce composant permet par exemple d'assurer une protection contre des coups de foudre susceptibles de se produire sur une ligne téléphonique ou des surtensions provenant de la mise en contact d'un fil téléphonique et d'un fil d'une ligne du réseau électrique.

Le circuit représenté en figure 11A utilisant une double diode de Shockley comme élément de protection fonctionne bien, mais il nécessite l'association de plusieurs éléments discrets : une double diode de Shockley, et un pont redresseur lui-même souvent réalisé sous forme de deux composants de silicium intégrant chacun une branche du pont et montés dans un même boîtier.

On va montrer que la présente invention permet de réaliser un tel pont protégé contre des surtensions ou des surintensités sous forme de composant monolithique.

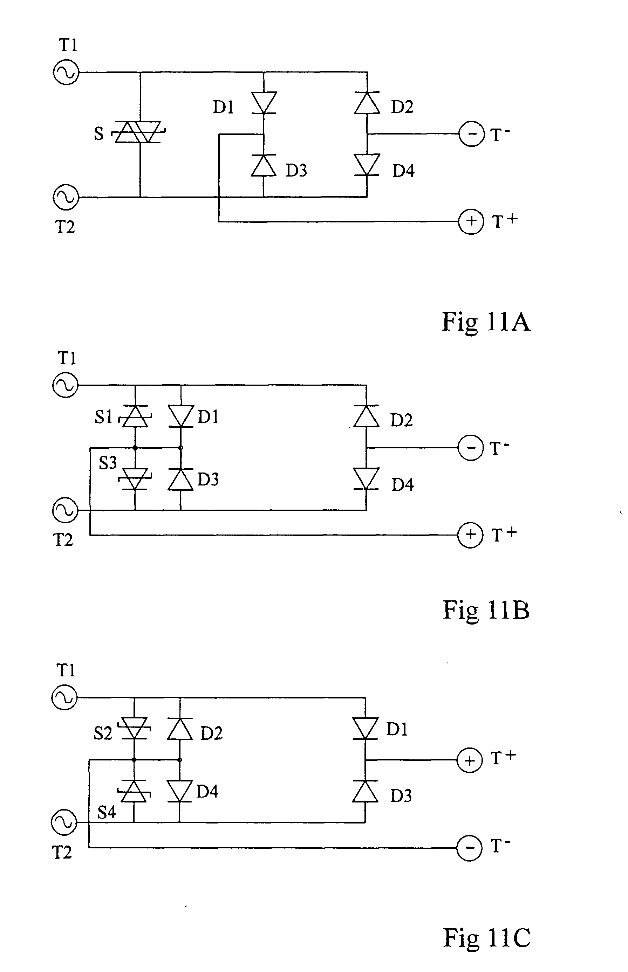

La présente invention se base sur une analyse du circuit de la figure 11A. La demanderesse n'a pas trouvé de moyen de réaliser ce circuit, tel quel, sous forme monolithique. Néanmoins, elle propose des variantes du circuit de la figure 11A telles qu'illustrées en figures 11B et 11C.

Dans le circuit de la figure 11B, la diode S est remplacée par deux diodes de Shockley unidirectionnelles tête-bêche S1 et S3 connectées entre les bornes T1 et T2 et dont l'anode commune est reliée à la cathode commune des diodes D1 et D3.

Dans le circuit de la figure 11C, la diode S est remplacée par deux diodes de Shockley unidirectionnelles tête-bêche S2 et S4 connectées entre les bornes T1 et T2 et dont la cathode commune est reliée à l'anode commune des diodes D2 et D4.

Dans chacun des schémas des figures 11B et 11C, on a rapproché respectivement les diodes D1-S1, D3-S3 et D2-S2, D4-S4 car, comme on le verra ci-après, la réalisation sous forme de composant monolithique proposée associe plus particulièrement ces diodes qui présentent une borne commune.

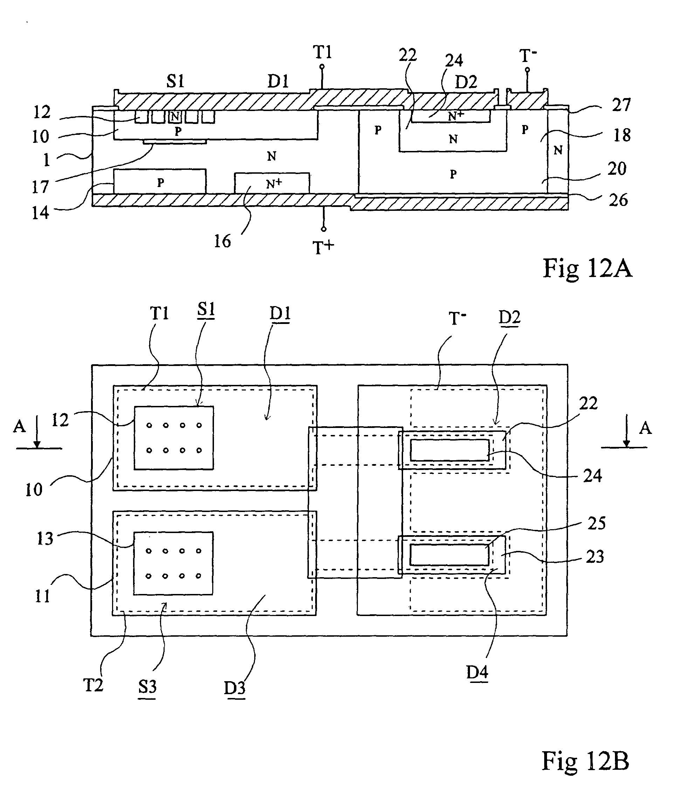

Le composant illustré en figures 12A et 12B, qui met en oeuvre le circuit de la figure 11B, est réalisé à partir d'une plaquette de silicium 1 de type N faiblement dopée. Comme le montrent ces figures, les diodes de Shockley S1 et S3 ainsi que les diodes en anti-parallèle D1 et D3 sont réalisées sous forme verticale dans la partie gauche du composant et les diodes D2 et D4 sont formées dans une section isolée dans la partie droite du composant.

La partie gauche du composant comprend deux caissons P 10 et 11 formés à partir de la face supérieure du substrat 1. Dans sensiblement la moitié de la surface de chacun de ces caissons est formée une région de type N, respectivement 12, 13, qui constitue la cathode d'une diode de Shockley S1, S3. Ces régions 12 et 13 sont de façon classique discontinues de sorte que des portions du matériau des caissons 10, 11 remontent dans des ouvertures de ces régions 12, 13, pour former ce qui est couramment appelé des courts-circuits d'émetteur. Sensiblement sous chacune des couches 12 et 13, sont formées à partir de la face inférieure du substrat des régions P dont seule la région 14 située sous la région 12 est visible en figure 12A. Ces régions P constituent les anodes des diodes de Shockley. Sous la partie des caissons 10 et 11 qui ne comprend pas les régions N 12 et 13 est formée à partir de la face inférieure du substrat une région de type N⁺ dont seule la région 16 correspondant à la cathode de la diode D1 est visible. De préférence, sous la région 12 (et symétriquement sous la région 13), à l'interface entre la région 10 et le substrat 1, une région 17 de type N, plus fortement dopée que le substrat, fixe la tension de retournement des diodes de Shockley.

Les diodes D2 et D4 sont formées dans la partie droite des figures 12A et 12B. Ces diodes sont réalisées dans des sections isolées. Dans le mode de réalisation de la figure 12, ces sections isolées sont formées à partir d'une diffusion profonde 18 s'étendant à partir de la surface supérieure qui rejoint une diffusion profonde 20 formée à partir de la face inférieure. Ces diffusions 18 et 20 de type P délimitent dans le substrat deux caissons de type N 22 et 23 à l'intérieur desquels sont formées des zones surdopées respectives de type N⁺ 24 et 25. La jonction entre le caisson de type N 22 et les diffusions P 18, 20 correspond à la diode D2 et la jonction entre le caisson de type N 23 et les diffusions P 18, 20 correspond à la diode D4.

La face inférieure de la diffusion profonde de type P 20 est recouverte d'une couche isolante, couramment une couche d'oxyde de silicium 26. De même, la surface supérieure apparente du composant est revêtue d'une couche d'oxyde de silicium 27 ouverte aux endroits où l'on souhaite établir des contacts entre des zones du composant et des métallisations.

La face inférieure du composant est uniformément revêtue d'une métallisation qui correspond à la borne T⁺ du schéma de la figure 11B. En ce qui concerne la vue de dessus, le contour des métallisations est représenté en pointillés en figure 12B. Une première métallisation correspondant à la borne d'alimentation alternative T1 est en contact avec la surface supérieure de la région N 12, du caisson 10 et de la région N⁺ 24. Une deuxième métallisation T2 correspondant à la deuxième borne d'alimentation alternative T2 est symétriquement déposée sur la couche 13, le caisson 11, et la surface supérieure de la région N⁺ 25. La surface supérieure de la région à diffusion profonde de type P 18 est revêtue d'une métallisation correspondant à la borne T⁻.

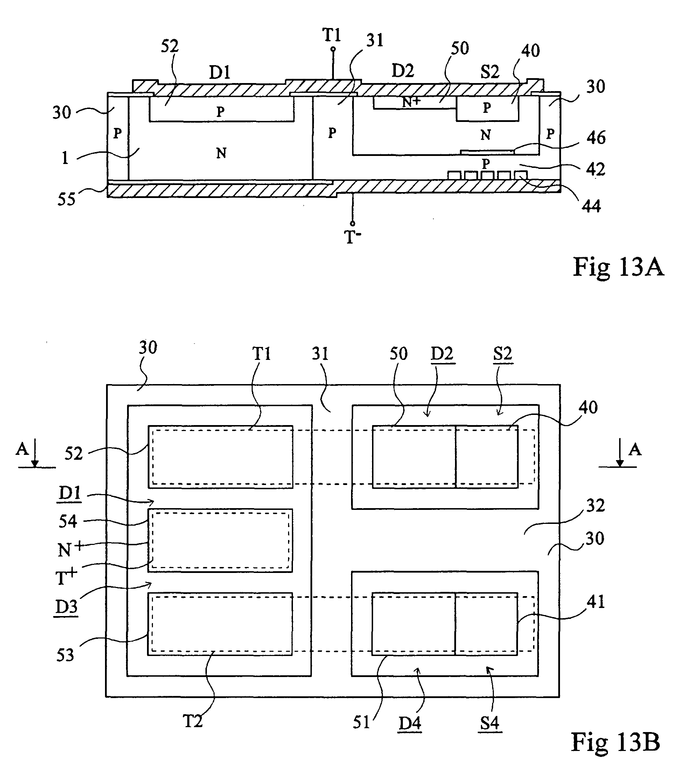

Pour réaliser un composant monolithique correspondant au schéma de circuit de la figure 11C, on pourrait utiliser le schéma des figures 12A et 12B en inversant tous les types de conductivité des diverses couches. Néanmoins, pour des raisons technologiques, on préfèrera souvent en pratique réaliser un composant monolithique à partir d'un substrat semiconducteur de type N. Les figures 13A et 13B représentent une vue en coupe et une vue de dessus d'un mode de réalisation de composant monolithique selon la présente invention correspondant au schéma de la figure 11C.

Le composant est réalisé à partir d'un substrat de type N, désigné comme précédemment par la référence 1. Les diodes S2, D2, S4, D4 sont réalisées dans la partie droite de la figure et les diodes D1, D3 dans la partie gauche.

L'ensemble du composant est entouré d'un mur de type P 30 constitué par la jonction d'une diffusion montante et d'une diffusion descendante réalisées à partir des faces inférieure et supérieure. En même temps est réalisé un mur central 31 séparant la plaquette en deux parties. En outre un mur 32 (voir figure 13B) sépare les régions où sont formées les diodes D2-S2 et D4-S4.

La diode de Shockley S2, visible en coupe en figure 13A, comprend, à partir de la surface supérieure du substrat, une région de type P 40 formant anode, le substrat 1 de type N, une région de type P 42 formée à partir de la surface inférieure et dans laquelle est formée une région de type N 44 munie, comme la région 12 de la figure 12, de trous de court-circuit d'émetteur. Une région de type N⁺ 46 est formée à l'interface de la région de type P 42 et du substrat de type N pour fixer le seuil de déclenchement de la diode de Shockley.

La diode D2 comprend, de la surface supérieure à la surface inférieure, une région N⁺ 50 adjacente à la région 40, et qui constitue la cathode de cette diode, le substrat N, et une extension de la région 42 de type P qui correspond à son anode.

Les diodes S4 et D4 sont identiques aux diodes S2 et D2 et leur vue de dessus apparaît en figure 13B où l'on peut voir les régions 41 et 51 qui correspondent respectivement aux régions 40 et 50.

Les diodes D1 et D3 sont formées dans une section isolée délimitée par le mur d'isolement 30, 31. Dans la surface supérieure du substrat sont formées des régions de type P 52 et 53 correspondant respectivement aux anodes des diodes D1 et D3 et une région de type N⁺ 54 correspondant aux cathodes communes de ces diodes. La surface inférieure du caisson délimité par les murs d'isolement 30, 31 est revêtue d'une couche isolante 55.

Une métallisation est formée sur la face inférieure et correspond à la borne T⁻ de la figure 11C. Une métallisation est formée sur la région de type N⁺ 54 et correspond à la borne T⁺. Une métallisation correspondant à la borne T1 recouvre la région P 52, la région N⁺ 50 et la région P 40, et une métallisation correspondant à l'électrode T2 recouvre les régions 53, 51 et 41.

Il sera clair pour l'homme de métier que les vues de dessus des figures 12B et 13B ne sont données qu'à titre illustratif. Ces vues de dessus sont extrêmement schématiques et diverses formes pourront être adoptées par l'homme de métier, notamment en ce qui concerne le choix des zones actives des divers éléments du composant, pour assurer des caractéristiques de conduction souhaitées.

Selon un autre de ses aspects, la présente invention prévoit un composant, également réalisé sous forme monolithique, capable non seulement de constituer un pont redresseur protégé contre des surtensions mais également de constituer un pont redresseur protégé contre des surintensités.

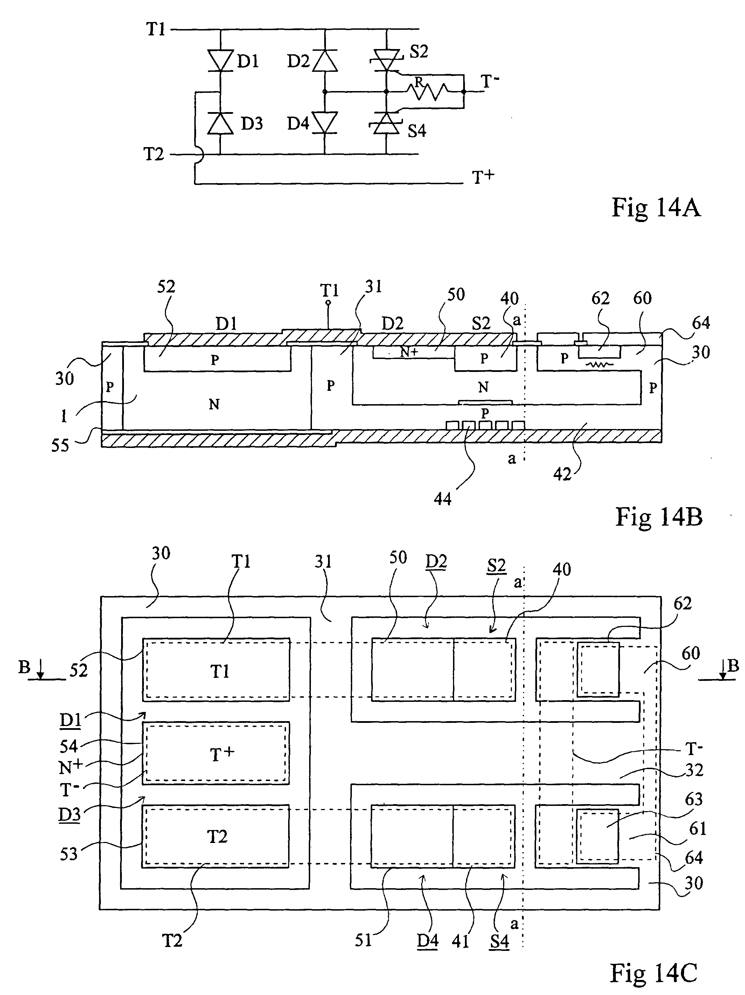

La figure 14A représente un schéma de circuit assurant cette fonction. Les diodes de Shockley correspondent alors à des thyristors dont la gâchette est connectée à la borne T⁻ qui est reliée au point de connexion des cathodes de ces thyristors et des anodes des diodes D2 et D4 par une résistance R. Ainsi, les composants S2 et S4 peuvent ou bien, en cas de surtension, fonctionner comme précédemment en tant que diodes de Shockley ou bien, quand le courant dans la résistance R, c'est-à-dire le courant du pont, dépasse un certain seuil fonctionner en tant que thyristors.

Les figures 14B et 14C représentent respectivement une vue en coupe et une vue de dessus d'un composant monolithique, dérivé du composant de figures 13A et 13B permettant de réaliser le circuit de la figure 14A. Ce composant, à gauche d'une ligne a-a, est identique au composant illustré en figures 13A et 13B à l'exception du fait que la métallisation de face arrière n'est pas connectée. De mêmes éléments y sont désignés par de mêmes références et cette partie gauche des figures 14B et 14C ne sera pas décrite à nouveau.

Dans la partie droite du composant des figures 14B et 14C, du côté de la surface inférieure, la couche 42 est prolongée de même que la métallisation de face inférieure. Du côté de la face supérieure, des régions supplémentaires 60 et 61 de type P, disjointes de la région P 40 s'étendent jusqu'au mur P 30. Des régions 62 et 63 de type N sont respectivement diffusées dans les régions 60 et 61.

Une métallisation reliée à la borne T⁻ est solidaire des régions P 60 et 61 du côté de ces régions opposé au mur 30, les diffusions de type N 62 et 63 étant disposées entre cette métallisation et le mur 30. Ainsi, la face arrière du composant qui constituait précédemment la borne T⁻ est maintenant reliée à la borne T⁻ par le mur 30 et les résistances pincées de valeurs respectives 2R sous les diffusions de type N 62 et 63. Une métallisation supplémentaire 64, non connectée à une borne externe, est formée sur la surface apparente du mur 30 et des régions 62 et 63. En fonctionnement normal, les résistances 2R en parallèle se trouvent connectées en série entre une borne d'entrée du pont et la borne de sortie T⁻ du pont.

Si une surtension se produit et rend par exemple la diode de Shockley S2 conductrice, cette surtension s'écoule par la diode S2 et la diode D4 par le trajet comprenant la métallisation T1, la région P 40, le substrat N, la région P 42, la région N 44, la métallisation de face inférieure, la région P 42, le substrat 1 et la région d'anode 51 de la diode D4 reliée à la métallisation T2. Ce trajet ne peut se voir dans la vue en coupe de la figure 14B prise selon la ligne B-B de la figure 14C puisqu'il implique la partie inférieure de la vue de dessus de la figure 14C.

Supposons maintenant qu'en cas de fonctionnement normal du pont redresseur D1-D4, une surintensité apparaisse alors qu'un courant s'écoule entre la borne T1 et la borne T⁻ en passant par la diode D2, c'est-à-dire que le courant suit le trajet allant de la métallisation T1, la région 50, le substrat 1, la région 42, la métallisation inférieure, le mur 30, vers la métallisation T⁻. Entre le mur 30 et la métallisation T⁻, le courant se divise en deux ; une partie passe dans la couche 60 sous la région 62, l'autre partie passe dans la couche 61 sous la région 63. Chacun des trajets a une résistance 2R. La résistance équivalente est donc bien égale à R. Quand le courant dans la résistance pincée sous la région diffusée 62 ou 63 excède une certaine valeur et que la chute de tension aux bornes de cette résistance dépasse 0,7 volt, les jonctions PN 60-62 et 61-63 deviennent passantes. Or, la jonction 61-63 fait partie d'un thyristor dont la région N 63 constitue la cathode, la région P 61 la région de gâchette de cathode, le substrat la base et la région P 40 ou 41 l'anode. En conséquence, ce thyristor devient passant et il se produit une injection de charges dans le substrat 1, ce qui déclenche la diode de Shockley verticale S4. La surintensité s'écoule alors à travers la diode de Shockley S4 et la diode D2 par un trajet non-visible dans la vue en coupe de la figure 14B.

Le cas décrit précédemment correspond au cas où la surintensité se produit alors que la borne T2 est plus positive que la borne T1. Dans ce cas, le court-circuit se produit tandis que S4 et D2 sont en direct, comme cela a été indiqué. Dans le cas où la borne T1 est plus positive que la borne T2, les mêmes mécanismes déclencheront la diode de Shockley S2 et le court-circuit se produit à travers D4 et S2.

D'autre part, dans le cas décrit précédemment, la résistance R (constituée de deux résistances 2R en parallèle) a été intégrée. On pourra également prévoir une résistance R externe au boîtier et de valeur ajustable ce qui permet une sélection du niveau du courant de protection.

Cette réalisation d'un pont protégé contre des surtensions ou des surintensités est susceptible de diverses variantes et modifications qui apparaîtront à l'homme de l'art. Par exemple, le point de jonction des diodes S2, S4, D2, D4 (figure 11C) ou le point de jonction des diodes S1, S3, D1, D3 (figure 11B) pourrait être connecté à une borne extérieure par l'intermédiaire d'une diode supplémentaire en anti-parallèle avec une diode de Shockley supplémentaire pour assurer une protection par rapport à un potentiel de référence tel que la masse. Il faut alors, dans le cas du schéma de la figure 12B répéter la structure verticale comprenant l'ensemble S1-D1 ou l'ensemble S3-D3 et, dans le mode de réalisation de la figure 13B, répéter le motif vertical comprenant l'ensemble S2-D2 ou S4-D4.

Ces exemples d'application n'ont été donnés que pour illustrer les nombreuses possibilités offertes par le concept de circuit intégré haute tension de puissance selon l'invention permettant de réaliser des composants de puissance "autonomes" dans des "sections isolées" d'un substrat.

## Revendications

1. Assemblage monolithique de composants semiconducteurs de puissance verticaux formés sur toute l'épaisseur d'une plaquette semiconductrice d'un premier type de conductivité faiblement dopée dont la face arrière est uniformément revêtue d'une métallisation, **caractérisé en ce que** certains au moins de ces composants, dits composants autonomes, sont formés dans des sections isolées du substrat dont l'isolement latéral est assuré par un mur diffusé du deuxième type de conductivité (6) et dont le fond est isolé par une couche diélectrique (7) interposée entre la face arrière du substrat et ladite métallisation (M).

2. Assemblage monolithique selon la revendication 1 **caractérisé en ce que**, quand la région semiconductrice de face arrière d'un composant autonome est du premier type de conductivité, il est prévu du côté de la face arrière une région surdopée du premier type de conductivité et, du côté de la face avant, en regard d'une portion au moins de cette région surdopée de face arrière, une région surdopée du premier type de conductivité sur laquelle est pris un contact.

3. Assemblage monolithique selon la revendication 1 **caractérisé en ce que**, quand la région semiconductrice de face arrière d'un composant autonome est du deuxième type de conductivité, cette région est prolongée latéralement jusqu'à un mur d'isolement, un contact étant repris sur la face supérieure du mur d'isolement, ladite couche diélectrique s'étendant sous les fondations inférieures du mur d'isolement.

4. Assemblage monolithique selon la revendication 1 **caractérisé en ce qu'**il comprend en outre au moins une section isolée dans laquelle sont formés des composants logiques.

5. Assemblage monolithique selon l'une quelconque des revendications 1 à 4, **caractérisé en ce que** le premier type de conductivité est le type N.

6. Composant monolithique constituant un pont de diodes, **caractérisé en ce qu'**il comprend dans un substrat d'un premier type de conductivité une première paire de diodes verticales (D1, D2) dont la cathode commune correspond à une métallisation recouvrant toute la face arrière et, dans une section isolée du substrat, séparée du reste du substrat par un mur d'isolement (P3) du deuxième type de conductivité, une deuxième paire de diodes verticales (D3, D4) dont l'anode commune correspond à une couche du deuxième type de conductivité formée du côté de la face arrière dont le contact est repris du côté de la face supérieure par l'intermédiaire du mur d'isolement (P3), la partie de la surface inférieure des diodes de la deuxième paire de diodes (D3, D4) étant revêtue d'une couche isolante (7) interposée entre la tranche semiconductrice et la métallisation de face arrière.

7. Composant selon la revendication 6, comprenant deux diodes de Shockley (S1, S3 ; S2, S4) en anti-parallèle sur les diodes de la première paire de diodes.

8. Composant selon la revendication 7, formé dans un substrat d'un premier type de conductivité ayant une face supérieure et une face inférieure comprenant
du côté de la face supérieure, deux premières régions du deuxième type de conductivité (10, 11) dans lesquelles sont formées deux deuxièmes régions du premier type de conductivité (12, 13) ;
du côté de la face inférieure, deux troisièmes régions du deuxième type de conductivité (14) situées sous les deuxièmes régions et deux quatrièmes régions du premier type de conductivité (16) situées sous les portions des premières régions ne contenant pas les deuxièmes régions ;
deux caissons du premier type de conductivité (22, 23) délimités par des murs d'isolement (18, 20) du deuxième type de conductivité traversant tout le substrat ;
une première métallisation (T1) en contact avec la surface d'une des premières régions, de la deuxième région correspondante et d'un caisson ;
une deuxième métallisation (T2) en contact avec la surface de l'autre première région, de l'autre deuxième région correspondante, et de l'autre caisson ;
une troisième métallisation (T⁺) en contact avec la surface supérieure du mur d'isolement ; et
une quatrième métallisation (T⁻) en contact avec la surface inférieure du substrat à l'exclusion du mur d'isolement et de la région qu'il délimite.

9. Composant selon la revendication 8, **caractérisé en ce que** les deuxièmes régions sont discontinues.

10. Composant selon la revendication 8, **caractérisé en ce que** la partie inférieure du mur d'isolement est constituée d'une région (20) s'étendant sous les caissons.

11. Composant selon la revendication 8, **caractérisé en ce que** la quatrième métallisation recouvre toute la surface inférieure du composant, la surface inférieure du mur d'isolement et celle de la région qu'il délimite étant recouvertes d'une couche isolante telle que de l'oxyde de silicium.

12. Composant selon la revendication 7, formé dans un substrat d'un premier type de conductivité ayant une face supérieure et une face inférieure comprenant
des première, deuxième et troisième parties de substrat délimitées par des murs d'isolement (30, 31, 32) du deuxième type de conductivité ;
du côté de la face supérieure, une première région du deuxième type de conductivité (40, 41) dans chacune des première et deuxième parties ;
du côté de la face inférieure, dans les première et deuxième parties, une deuxième région du deuxième type de conductivité (42) dans laquelle sont formées, sous chacune des deux premières régions, deux troisièmes régions du premier type de conductivité (44) ;
dans la troisième partie, deux quatrièmes régions du deuxième type de conductivité (52, 53) ;
une première métallisation (T1) en contact avec la surface supérieure de la première partie, de la première région correspondante et d'une quatrième région ;
une deuxième métallisation (T2) en contact avec la surface supérieure de la deuxième partie, de la première région correspondante et de l'autre quatrième région ;
une troisième métallisation, en contact avec la surface supérieure de la troisième partie ; et
une quatrième métallisation en contact avec la surface inférieure du composant sauf la région correspondant à la troisième partie.

13. Composant selon la revendication 12, **caractérisé en ce que** les troisièmes régions sont discontinues.

14. Composant selon la revendication 12, **caractérisé en ce que** les contacts avec des régions des première, deuxième et troisième parties de la surface supérieure du substrat sont assurés par l'intermédiaire de régions surdopées du premier type de conductivité.

15. Composant selon l'une quelconque des revendications 7 à 14, **caractérisé en ce qu'**il comprend en outre des moyens de déclenchement en cas de surintensité.

16. Composant selon la revendication 15, prise dans son rattachement avec la revendication 12, **caractérisé en ce qu'**il comprend :
des cinquièmes régions du deuxième type de conductivité (60, 61) voisines des premières régions (40, 41) qui rejoignent un mur d'isolement et comprennent chacune une sixième région (62, 63) du premier type de conductivité séparant ces cinquièmes régions en deux zones ;
une cinquième métallisation en contact avec la zone des cinquièmes régions éloignée du mur d'isolement ; et
une sixième métallisation en contact avec le mur d'isolement et les sixièmes régions.

## Patentansprüche

1. Monolithisches Aggregat von vertikalen Halbleiter-Leistungsbauteilen, die über die gesamte Dicke eines schwach dotierten Halbleiterplättchens oder -chips von einem ersten Leitfähigkeitstyp ausgebildet sind, deren Rück- bzw. Unterseite gleichförmig mit einer Metallisierung überzogen sind, **dadurch gekennzeichnet, daß** von diesen Bauteilen wenigstens bestimmte, sogenannte autonome Bauteile in isolierten Abschnitten des Substrats ausgebildet sind, deren seitliche Isolierung durch eine Diffusionsmauer bzw. -wandung (6) vom zweiten Leitfähigkeitstyp gewährleistet wird und deren Boden durch eine zwischen der Rück- bzw. -unterseite des Substrats und der genannten Metallisierung (M) angeordnete dielektrische Schicht (7) isoliert ist.

2. Monolithisches Aggregat nach Anspruch 1, **dadurch gekennzeichnet, daß** wenn der Halbleiterbereich der Rück-bzw. -unterseite eines autonomen Bauteils vom ersten Leitfähigkeitstyp ist, auf der Rück-bzw.-unterseite ein stark dotierter Bereich vom ersten Leitfähigkeitstyp und auf der Vorderseite in Ausrichtung mit wenigstens einem Teil dieses stark dotierten Bereichs der Rückseite ein stark dotierter Bereich vom ersten Leitfähigkeitstyp vorgesehen sind, an welchem eine Kontaktierung erfolgt.

3. Monolithisches Aggregat nach Anspruch 1, **dadurch gekennzeichnet, daß** wenn der Halbleiterbereich an der Rückseite eines autonomen Bauteils vom zweiten Leitfähigkeitstyp ist, dieser Bereich in seitlicher Richtung bis zu einer Isoliermauer bzw. -wandung verlängert ist, wobei auf der Oberseite dieser Isoliermauer bzw. -wandung eine Kontaktierung vorgesehen ist und die genannte dielektrische Schicht sich unter die Sohle der Isoliermauer bzw. -wandung erstreckt.

4. Monolithisches Aggregat nach Anspruch 1, **dadurch gekennzeichnet, daß** es des weiteren wenigstens einen isolierten Abschnitt umfaßt, in welchem Logikbauteile ausgebildet sind.

5. Monolithisches Aggregat nach einem der Ansprüche 1 bis 4, **dadurch gekennzeichnet, daß** der erste Leitfähigkeitstyp der N-Typ ist.

6. Monolithisches Bauteil, das eine Diodenbrücke bildet, **dadurch gekennzeichnet, daß** es in einem Substrat eines ersten Leitfähigkeitstyps ein erstes Paar vertikaler Dioden (D1,D2) umfaßt, deren gemeinsame Kathode einer die gesamte Rückseite bedeckenden Metallisierung entspricht, und daß es in einem isolierten Abschnitt des Substrats, von dem übrigen Substrat durch eine Isoliermauer bzw. -wandung (P3) des zweiten Leitfähigkeitstyps getrennt ein zweites Paar vertikaler Dioden (D3,D4) umfaßt, deren gemeinsame Anode einer an der Rückseite ausgebildeten Schicht des zweiten Leitfähigkeitstyps entspricht, deren Kontaktierung von der Oberseite her über die Isoliermauer bzw. -wandung (P3) erfolgt, wobei der Bereich der Unterseite der Dioden des zweiten Paars von Dioden (D3,D4) mit einer Isolierschicht (7) überzogen ist, welche zwischen dem Halbleiterplättchen bzw. -chip und der Rückseiten-Metallisierung angeordnet ist.

7. Bauteil nach Anspruch 6, welches zwei Shockleydioden (S1,S3;S2,S4) in Antiparallelschaltung über den Dioden des ersten Diodenpaars aufweist.

8. Bauteil nach Anspruch 7, welches in einem Substrat eines ersten Leitfähigkeitstyps mit einer Ober- bzw. Vorderseite und einer Unter-bzw. Rückseite ausgebildet ist und umfaßt:
an der Ober- bzw. Vorderseite zwei erste Bereiche (10,11) des zweiten Leitfähigkeitstyps, in welchen zwei zweite Bereiche (12,13) des ersten Leitfähigkeitstyps ausgebildet sind;
an der Unter- bzw. Rückseite zwei dritte Bereiche (14) des zweiten Leitfähigkeitstyps in Anordnung unter den zweiten Bereichen, sowie zwei vierte Bereiche (16) des ersten Leitfähigkeitstyps in Anordnung unter den Teilen der ersten Bereiche, welche nicht die zweiten Bereiche enthalten;
zwei Kästen bzw. Gräben (22,23) des ersten Leitfähigkeitstyps, welche durch das gesamte Substrat durchsetzende Isoliermauern bzw. -wandungen (18,20) begrenzt sind;
eine erste Metallisierung (T1) in Kontakt mit der Oberfläche eines der ersten Bereiche, des entsprechenden zweiten Bereichs und eines Grabens;
eine zweite Metallisierung (T2) in Kontakt mit der Oberfläche des anderen ersten Bereichs, des entsprechenden anderen zweiten Bereichs und des anderen Grabens;
eine dritte Metallisierung (T⁺) in Kontakt mit der Ober- bzw. Vorderseite der Isoliermauer bzw. -wandung;
sowie eine vierte Metallisierung (T⁻) in Kontakt mit der Unterseite des Substrats, ausgenommen die Isoliermauer bzw. -wandung und den von ihr begrenzten Bereich.

9. Bauteil nach Anspruch 8, **dadurch gekennzeichnet, daß** die zweiten Bereiche diskontinuierlich sind.

10. Bauteil nach Anspruch 8, **dadurch gekennzeichnet, daß** der untere Teil der Isoliermauer bzw. -wandung aus einem sich unter die Gräben erstreckenden Bereich (20) besteht.

11. Bauteil nach Anspruch 8, **dadurch gekennzeichnet, daß** die vierte Metallisierung die gesamte Unter- bzw. Rückseite des Bauteils bedeckt, wobei die Unterseite der Isoliermauer bzw. -wandung und die Unterseite des von dieser begrenzten Bereichs mit einer Isolierschicht beispielsweise aus Siliziumoxyd überzogen ist.

12. Bauteil nach Anspruch 7, welches in einem Substrat eines ersten Leitfähigkeitstyps mit einer Ober-bzw. Vorderseite und einer Unter- bzw. Rückseite ausgebildet ist und umfaßt:
durch Isoliermauern bzw. -wände (30, 31,32) des zweiten Leitfähigkeitstyps begrenzte erste, zweite und dritte Teile des Substrats;
auf der Ober- bzw. Vorderseite einen ersten Bereich des zweiten Leitfähigkeitstyps in jedem der ersten und zweiten Teile;
auf der Unter- bzw. Rückseite in dem ersten und zweiten Teil einen zweiten Bereich (42) des zweiten Leitfähigkeitstyps, in welchem, jeweils unter jedem der zwei ersten Bereiche, zwei dritte Bereiche (44) des ersten Leitfähigkeitstyps ausgebildet sind;
in dem dritten Teil zwei vierte Bereiche (52, 53) des zweiten Leitfähigkeitstyps;
eine erste Metallisierung (T1) in Kontakt mit der Oberseite des des ersten Teils, des entsprechenden ersten Bereichs und eines vierten Bereichs;
eine zweite Metallisierung (T2) in Kontakt mit der Oberseite des zweiten Teils, des entsprechenden ersten Bereichs und des anderen vierten Bereichs;
eine dritte Metallisierung in Kontakt mit der Oberseite des dritten Teils; sowie
eine vierte Metallisierung in Kontakt mit der Oberseite des Bauteils, ausgenommen den dem dritten Teil entsprechenden Bereich.

13. Bauteil nach Anspruch 12, **dadurch gekennzeichnet, daß** die dritten Bereiche diskontinuierlich sind.

14. Bauteil nach Anspruch 12, **dadurch gekennzeichnet, daß** die Kontakte mit den Bereichen des ersten, zweiten und dritten Teils der Oberseite des Substrats vermittels stark dotierter Bereiche des ersten Leitfähigkeitstyps gewährleistet werden.

15. Bauteil nach einem der Ansprüche 7 bis 14, **dadurch gekennzeichnet daß** es des weiteren Mittel zur Triggerung im Fall eines Überstroms aufweist.

16. Bauteil nach Anspruch 15, in Verbindung mit Anspruch 12, **dadurch gekennzeichnet, daß** das Bauteil umfaßt:
fünfte Bereiche (60, 61) vom zweiten Leitfähigkeitstyp benachbart den ersten Bereichen (40, 41), welche eine Isoliermauer bzw. -wandung berühren und jeder jeweils einen sechsten Bereich (62,63) des ersten Leitfähigkeitstyps aufweisen, welcher die fünften Bereiche in zwei Zonen trennt;
eine fünfte Metallisierung in Kontakt mit der von der Isoliermauer bzw. -wandung entfernten Zone der fünften Bereiche;
sowie eine sechste Metallisierung in Kontakt mit der Isoliermauer bzw. -wandung und den sechsten Bereichen.

## Claims

1. A monolithic assembly of vertical power semiconductor components formed throughout the thickness of a low doped semiconductive wafer of a first conductivity type having a bottom surface and an upper surface, whose bottom surface is uniformly coated with a metallization, **characterized in that** some at least of said components, so-called autonomous components, are formed in insulated sections of the substrate, whose lateral insulation is provided by a diffused wall (6) of the second conductivity type and whose bottom is insulated by a dielectric layer (7) interposed between the bottom surface of the substrate and said metallization (M).

2. The monolithic assembly of claim 1, **characterized in that**, when the semiconductive region of the bottom surface of an autonomous component is of the first conductivity type, an overdoped region of the first conductivity type is provided on the bottom surface and, facing at least a portion of the overdoped region of the bottom surface, an overdoped region of the first conductivity type from which a contact is taken, is formed on the upper surface.

3. The monolithic assembly of claim 1, **characterized in that**, when the semiconductive region of the bottom surface of an autonomous component is of the second conductivity type, said region laterally extends up to an insulation wall, a contact being taken on the upper surface of the insulation wall, said dielectric layer extending beneath the bottom surface of the insulation wall.

4. The monolithic assembly of claim 1, **characterized in that** it further comprises at least one insulated section in which logic components are formed.

5. The monolithic assembly of any of claims 1 to 4, **characterized in that** the first conductivity type is N.

6. A monolithic component constituting a diode bridge **characterized in that** it includes, in a substrate of a first conductivity type, a first pair of vertical diodes (D1, D2) whose common cathodes correspond to metallization covering all the bottom surface and, in an insulated section of the substrate, separated from the rest of the substrate by an insulation wall (P3) of the second conductivity type, a second pair of vertical diodes (D3, D4) whose common anodes correspond to a layer of the second conductivity type formed on the bottom surface whose contact is taken from the upper surface through the insulation wall (P3), the portion of the bottom surface of the diodes (D3, D4) of the second pair being coated with an insulating layer (7) interposed between the semiconductive wafer and the bottom surface metallization.

7. A component according to claim 6, including two head-to-tail Shockley diodes (S1, S3; S2, S4) in antiparallel with the diodes of the first pair of diodes.

8. The component of claim 7, formed in a substrate of a first conductivity type having an upper and a bottom surface, comprising:
on the upper surface, two first regions of a second conductivity type (10, 11) in which are formed two second regions of the first conductivity type (12, 13);
on the bottom surface, two third regions of the second conductivity type (14) disposed beneath the second regions, and two fourth regions of the first conductivity type (16) disposed beneath the portions of the first regions that do not contain the second regions;
two wells of the first conductivity type (22, 23) delineated by insulation walls (18, 20) of the second conductivity type extending throughout the substrate;
a first metallization (T1) contacting the surface of one of the first regions, of the corresponding second region and of a well;
a second metallization (T2) contacting the surface of the other first region, of the other corresponding second region, and of the other well;
a third metallization (T⁺) contacting the upper surface of the insulation wall; and
a fourth metallization (T⁻) contacting the bottom surface of the substrate except the insulation wall and the region delineated by the wall.

9. The component of claim 8, **characterized in that** the second regions are discontinuous.

10. The component of claim 8, **characterized in that** the bottom portion of the insulation wall is formed by a region (20) extending beneath the wells.

11. The component of claim 8, **characterized in that** the fourth metallization coats the whole bottom surface of the component, the bottom surface of the insulation wall and the surface of the region delineated thereby being coated with an insulation layer such as silicon oxide.

12. The component of claim 7, formed in a substrate of a first conductivity type having an upper surface and a bottom surface; comprising:
first, second and third substrate portions delineated by insulation walls (30, 31, 32) of the second conductivity type;
on the side of the upper surface, a first region of the second conductivity type (40, 41) in each first and second portion;
on the side of the bottom surface, in each first and second portion, a second region (42) of the second conductivity type in which are formed, beneath each of the first two regions, two third regions (44) of the first conductivity type;
in the third portion, two fourth regions (52, 53) of the second conductivity type;
a first metallization (T1) contacting the upper surface of the first portion, of the first corresponding region and of a fourth region;
a second metallization (T2) contacting the upper surface of the second portion, of the first corresponding region and of the other fourth region;
a third metallization contacting the upper surface of the third portion; and
a fourth metallization contacting the bottom surface of the component except the region corresponding to the third portion.

13. The component of claim 12, **characterized in that** the third regions are discontinued.

14. The component of claim 12, **characterized in that** the contacts with the regions of the first, second and third portions of the upper surface of the substrate are ensured through overdoped regions of the first conductivity type.

15. The component of any of claims 7 to 14, **characterized in that** it further includes triggering means that are operative when an overcurrent occurs.

16. The component of claim 15, taken when attached to claim 12, **characterized in that** it includes:
fifth regions (60, 61) of the second conductivity type adjacent to the first regions (40, 41) that contact an insulation wall and include each a sixth region (62, 63) of the first conductivity type partitioning said fifth regions into two areas;
a fifth metallization contacting the area of the fifth regions that is disposed apart from the insulation wall; and
a sixth metallization contacting the insulation wall and the sixth regions.
